(19) Europäisches Patentamt
European Patent Office
Office européen des brevets

(11) **EP 4 016 596 A1**

(12) **DEMANDE DE BREVET EUROPEEN**

(43) Date de publication:
**22.06.2022 Bulletin 2022/25**

(21) Numéro de dépôt: **21214476.0**

(22) Date de dépôt: **14.12.2021**

(51) Classification Internationale des Brevets (IPC):
*H01L 21/66* (2006.01)     *H01L 31/0747* (2012.01)
*H02S 50/10* (2014.01)

(52) Classification Coopérative des Brevets (CPC):
**H01L 22/12; H01L 22/20; H01L 31/0747;
H02S 50/10**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **18.12.2020 FR 2013736**

(71) Demandeur: **Commissariat à l'Energie Atomique
et aux Energies
Alternatives
75015 Paris (FR)**

(72) Inventeurs:
• **VEIRMAN, Jordi
38054 GRENOBLE CEDEX 09 (FR)**
• **ALBARIC, Mickaël
38054 GRENOBLE CEDEX 09 (FR)**
• **DANEL, Adrien
38054 GRENOBLE CEDEX 09 (FR)**

(74) Mandataire: **Cabinet Camus Lebkiri
25 rue de Maubeuge
75009 Paris (FR)**

(54) **PROCÉDÉ DE DÉTERMINATION DE LA DURÉE DE VIE VOLUMIQUE DES PORTEURS DE
CHARGE D'UN SUBSTRAT ET DISPOSITIF ASSOCIÉ**

(57)     Un aspect de l'invention concerne un procédé de détermination (100) de la durée de vie volumique des porteurs de charge

$$\left(\tau_1^0\right)$$

d'un substrat échantillon (1) passivé au moyen de structures de passivation, comprenant :
- une étape de caractérisation (110) d'une vitesse de recombinaison (S) associée aux structures de passivation à partir d'un substrat témoin (2) passivé au moyen des structures de passivation et présentant une durée de vie volumique des porteurs de charge

$$\left(\tau_2^0\right)$$

connue ;
- une étape de mesure (122) de la durée de vie effective des porteurs de charges ($\tau_1$) du substrat échantillon (1) ;
- une étape de détermination (123) de la durée de vie volumique des porteurs de charges

$$\left(\tau_1^0\right)$$

du substrat échantillon (1) à partir de la durée de vie effective des porteurs de charges ($\tau_1$) et de la vitesse de recombinaison (S) associée aux structures de passivation.

[Fig. 1]

**Description**

**DOMAINE TECHNIQUE DE L'INVENTION**

Le domaine technique de l'invention concerne la caractérisation de substrats semiconducteurs et plus particulièrement la caractérisation de la durée de vie volumique des porteurs de charge dans les substrats semiconducteurs.

**ARRIÈRE-PLAN TECHNOLOGIQUE DE L'INVENTION**

Le rendement de conversion d'une cellule photovoltaïque dépend fortement des propriétés opto-électroniques du substrat qui la compose et notamment de la durée de vie des porteurs de charge. Plus la durée de vie des porteurs de charge est élevée et meilleur est le rendement de conversion. La durée de vie des porteurs de charge est fortement influencée par la densité de centres de recombinaison électron-trou du substrat. Il s'agit par exemple d'impuretés au sein du substrat qui crée localement des états électroniques au sein de la bande interdite, facilitant localement la recombinaison des électrons avec les trous. La présence de liaisons chimiques non satisfaites, par exemple à la surface du substrat non passivé, crée également des centres de recombinaison électron-trou.
On définit alors une durée de vie volumique des porteurs de charge $\tau_0$ (que l'on appellera également durée de vie volumique), dont l'unité est en $\mu$s, qui correspond à la durée de vie des porteurs de charge uniquement influencée par les recombinaisons dans le volume du substrat, sans prise en compte des recombinaisons en surface. La durée de vie volumique est égale à la durée de vie des porteurs de charge dans un substrat auquel les surfaces seraient repoussées à l'infini. Plus la qualité du substrat est élevée (absence d'impureté) et plus la durée de vie volumique est élevée. À l'heure actuelle, la durée de vie volumique d'un substrat destiné à l'industrie photovoltaïque est supérieure à 2000 $\mu$s.
On distingue également une vitesse de recombinaison $S$ des porteurs de charge à la surface d'un substrat, dont l'unité est en cm/s, représentant la vitesse de recombinaison des électrons avec des trous à la surface du substrat. Plus la surface présente de centres de recombinaison et plus la vitesse de recombinaison est élevée. Ainsi, la vitesse de recombinaison est un bon indicateur de la qualité de passivation des surfaces. Par exemple, une vitesse de recombinaison $S$ > 100 cm/s indique une passivation de qualité médiocre. Une vitesse de recombinaison 10 cm/s < $S$ < 100 cm/s indique une passivation de bonne qualité. Et une vitesse de recombinaison $S$ < 10 cm/s, voire $S$ < 1 cm/s, voire encore $S$ < 0,1 cm/s indique une passivation de très bonne qualité.
Pour un substrat d'épaisseur $W$, on définit une durée de vie effective des porteurs de charge $\tau$ (que l'on appellera également durée de vie effective) prenant en compte tant la durée de vie volumique que la vitesse de recombinaison à ses surfaces. La durée de vie effective $\tau$ est donnée par la relation suivante :

[Math. 1]

$$\frac{1}{\tau} = \frac{1}{\tau_0} + \frac{S_A + S_B}{W}$$

où $S_A$ et $S_B$ sont les vitesses de recombinaison de la face avant et de la face arrière du substrat. L'unité de l'épaisseur $W$ est préférentiellement en cm. Pour un substrat présentant les mêmes vitesses de recombinaison $S$ sur chacune des faces, la relation peut être simplifiée et devient :

[Math. 2]

$$\frac{1}{\tau} = \frac{1}{\tau_0} + \frac{2S}{W}$$

La durée de vie effective $\tau$ conditionne le rendement de conversion effectif d'une cellule photovoltaïque réalisée à partir du substrat. Il est donc nécessaire de maximiser cette quantité.
Pour cela, l'industrie photovoltaïque met en oeuvre des procédés de tri et de sélection des substrats à partir de la durée de vie volumique afin de sélectionner les meilleurs substrats pour réaliser des cellules photovoltaïques présentant un rendement de conversion élevé.
La durée de vie volumique peut être mesurée sur un lingot de semiconducteurs au sein duquel seront découpés les substrats. La mesure sur lingot permet d'approcher le cas idéal où les surfaces sont considérées comme suffisamment éloignées (épaisseur W >> 1). Ainsi la mesure de la durée de vie effective sur le lingot fournie une estimation fiable de la durée de vie volumique. Toutefois, la durée de vie volumique peut varier au sein même du lingot. Ainsi, les substrats issus du même lingot peuvent présenter des variations de durée de vie volumique. Il est donc nécessaire de pouvoir réaliser une mesure de la durée de vie volumique sur chaque substrat.

Le document [Yablonovitch & al., Unusually Low Surface-Recombination Velocity on Silicon and Germanium Surfaces", PRL, juillet 1986, Volume 57, Number 2] divulgue une méthode de mesure de la durée de vie volumique au sein d'un substrat de silicium. Le substrat de silicium est dans un premier temps passivé de façon à obtenir des surfaces remarquablement inactives d'un point de vue électronique. Ceci se traduit par une vitesse de recombinaison $S$ très faible. La passivation est obtenue par l'immersion du substrat dans un acide tel que l'acide fluorhydrique. Dans un second temps, la durée de vie effective des porteurs de charge est mesurée en fonction de l'épaisseur du substrat W de silicium. La durée de vie effective des porteurs de charge est mesurée par décroissance du signal de photoconductance. L'amincissement du substrat est obtenu par gravure chimique. Si la méthode proposée par Yablonovitch & al. permet effectivement d'obtenir la durée de vie volumique d'un substrat par résolution de l'équation [Math.1], en revanche, il est nécessaire de prévoir un substrat initialement beaucoup plus épais que les épaisseurs standards dans l'industrie photovoltaïque. Il existe donc un besoin de déterminer la durée de vie volumique des porteurs de charge d'un substrat présentant une épaisseur standard, typiquement pour la fabrication d'une cellule photovoltaïque.

Le document [Grant & al., Evaluation of the Bulk Lifetime of Silicon Wafers by Immersion in Hydrofluoric Acid and Illumination, ECS J. Solid State Sci. Technol. 1, p. 55, juillet 2012] divulgue une méthode de mesure de la durée de vie volumique au sein d'un substrat de silicium. Le substrat de silicium est d'abord passivé par immersion dans un bain d'acide fluorhydrique suivi d'une illumination du substrat immergé par un rayonnement de 0,2 soleil pendant 1 min. L'illumination du substrat par le rayonnement permet d'améliorer la passivation, réduisant davantage la vitesse de recombinaison aux surfaces du substrat. La durée de vie effective des porteurs de charge est mesurée immédiatement après l'illumination du substrat. La qualité de passivation aux surfaces permet d'obtenir directement une estimation basse de la durée de vie volumique des porteurs de charge à partir de la durée de vie effective des porteurs de charge en négligeant l'impact de la vitesse de recombinaison sur cette dernière. Toutefois, la méthode proposée par Grant & al. impose de réaliser la mesure de durée de vie effective immédiatement après l'illumination, complexifiant le dispositif de caractérisation qui doit permettre une illumination et une mesure immédiatement après d'un substrat immergé dans un bain d'acide.

De plus, les méthodes proposées par Grant & al. et Yablonovitch & al. impliquent toutes deux l'immersion du substrat dans une solution passivante tel que de l'acide fluorhydrique pour réaliser l'étape de mesure avec une vitesse de recombinaison faible. Malheureusement, la manipulation de ces solutions passivantes est dangereuse et complexe. Le niveau de passivation des surfaces du substrat évolue également en fonction du temps lorsque le substrat est retiré du bain de solution passivante, les surfaces réagissant plus ou moins vite avec l'air ambiant.

Il existe donc un besoin d'un procédé pour déterminer la durée de vie volumique d'un substrat, qui soit compatible avec les exigences de l'industrie photovoltaïque.

## RÉSUMÉ DE L'INVENTION

L'invention offre une solution aux problèmes évoqués précédemment, en permettant la détermination de la durée de vie volumique d'un substrat de façon simple et rapide, et sans recourir à l'utilisation d'une passivation spécifique.

L'invention concerne un procédé de détermination de la durée de vie volumique des porteurs de charge d'un substrat échantillon, le procédé comprenant :

- une étape de fourniture du substrat échantillon passivé au moyen d'une première structure de passivation disposée sur une première face du substrat échantillon et d'une deuxième structure de passivation disposée sur une deuxième face du substrat échantillon, la deuxième face du substrat échantillon étant opposée à la première face du substrat échantillon, le substrat échantillon présentant une première épaisseur ;

- une étape de caractérisation d'une vitesse de recombinaison associée à la première structure de passivation et à la deuxième structure de passivation, ladite étape comprenant :

  - une sous-étape de fourniture d'un substrat témoin passivé au moyen de la première structure de passivation disposée sur une première face du substrat témoin et de la deuxième structure de passivation disposée sur une deuxième face du substrat témoin, la deuxième face du substrat témoin étant opposée à la première face du substrat témoin, le substrat témoin présentant une deuxième épaisseur et une durée de vie volumique des porteurs de charge connue ;

  - une sous-étape de mesure de la durée de vie effective des porteurs de charge du substrat témoin ;

- une sous-étape de détermination de la vitesse de recombinaison associée aux première et deuxième structures de passivation à partir des durées de vie effective et volumique des porteurs de charge du substrat témoin, et de la deuxième épaisseur du substrat témoin ;

- une étape de mesure de la durée de vie effective des porteurs de charges du substrat échantillon ;

- une étape de détermination de la durée de vie volumique des porteurs de charges du substrat échantillon à partir de la durée de vie effective des porteurs de charge du substrat échantillon, de la première épaisseur du substrat échantillon et de la vitesse de recombinaison associée aux première et deuxième structures de passivation.

L'étape de caractérisation de la vitesse de recombinaison permet de déterminer la durée de vie volumique des porteurs de charges d'un substrat échantillon déjà passivé. Grâce à l'étape de caractérisation, la durée de vie volumique est obtenue sans retrait ni remplacement des structures de passivation du substrat échantillon. Ainsi, le substrat échantillon, par exemple mis en oeuvre dans un procédé de fabrication d'une cellule photovoltaïque, peut d'ores et déjà comporter les structures de passivation finales.

Le substrat échantillon étant passivé, il est électroniquement stable dans le temps. Ainsi, la mesure de la durée de vie volumique des porteurs de charge peut être réalisée ultérieurement, par exemple plusieurs minutes ou heures après l'étape de préparation des première et deuxième structures de passivation. Ceci permet ainsi de simplifier le système mettant en oeuvre le procédé, ses différents moyens pouvant être indépendants et distants.

L'étape de caractérisation permet de déterminer la vitesse de recombinaison associée aux première et deuxième structures de passivation même dans le cas où les structures de passivation sont différentes. Il est ainsi possible de déterminer la durée de vie volumique des porteurs de charges sur un substrat dit asymétrique, comprenant par exemple une jonction telle qu'une jonction PN.

La mise en oeuvre d'un substrat témoin dont l'épaisseur et la durée de vie volumique sont connues permet de déterminer la vitesse de recombinaison en conservant l'intégrité du substrat échantillon. En effet, il n'est pas nécessaire de retirer les structures de passivation ou encore d'amincir le substrat échantillon pour caractériser la vitesse de recombinaison, le substrat témoin pouvant, par exemple, être utilisé à cette fin. Ainsi, il n'est pas nécessaire de prévoir un substrat échantillon plus épais, le procédé de caractérisation étant compatible avec des substrats présentant des épaisseurs standards.

La mise en oeuvre d'un substrat témoin dont la durée de vie volumique des porteurs est connue permet de s'affranchir d'une étape de caractérisation de ladite durée de vie volumique et ainsi réduire le nombre d'étapes et le temps nécessaire à la détermination de la durée de vie volumique des porteurs de charge du substrat échantillon.

Le procédé ne réalisant qu'une caractérisation des structures de passivation et une mesure de la durée de vie effective des porteurs de charge du substrat échantillon, il est ainsi applicable à tout type de substrat semiconducteur, dès lors que le substrat échantillon est passivé au moyen des première et deuxièmes structures de passivation. Il peut par exemple s'agir d'un substrat semi-conducteur comprenant du silicium, du germanium ou des éléments des colonnes III et V.

Outre les caractéristiques qui viennent d'être évoquées dans le paragraphe précédent, le procédé de détermination selon l'invention peut présenter une ou plusieurs caractéristiques complémentaires parmi les suivantes, considérées individuellement ou selon toutes les combinaisons techniquement possibles :

- la sous-étape de fourniture comprend la passivation du substrat témoin de manière à déposer la première structure de passivation sur la première face du substrat témoin et la deuxième structure de passivation sur la deuxième face du substrat témoin ;

- l'étape de fourniture comprend la passivation du substrat échantillon de manière à déposer la première structure de passivation sur la première face du substrat échantillon et la deuxième structure de passivation sur la deuxième face du substrat échantillon ;

- le dépôt des première et deuxième structures de passivation est effectué sous une température inférieure à 250 °C ;

- la première structure de passivation et la deuxième structure de passivation comprennent chacune une couche de passivation en silicium amorphe hydrogéné intrinsèque ;

- la première structure de passivation comprend en outre une couche de silicium amorphe dopée selon un premier type de conductivité, disposée sur la couche de passivation en silicium amorphe hydrogéné intrinsèque, et dans lequel la deuxième structure de passivation comprend en outre une couche de silicium amorphe dopée selon un deuxième type de conductivité, disposée sur la couche de passivation en silicium amorphe hydrogéné intrinsèque ;

- le deuxième type de conductivité est opposé au premier type de conductivité ;

- le deuxième type de conductivité est identique au premier type de conductivité

- la première structure de passivation et la deuxième structure de passivation comprennent chacune une couche d'oxyde transparent conducteur disposée sur la couche de silicium amorphe dopée ;

- les première et deuxième structures de passivation sont telles que la vitesse de recombinaison associée aux première et deuxième structures de passivation est inférieure à 100 cm/s, préférentiellement inférieure ou égale à 10 cm/s.

- la résistivité du substrat témoin est sensiblement égale à la résistivité du substrat échantillon ;

- la sous-étape de fourniture consiste à fournir une pluralité d'échantillons témoins présentant des résistivités différentes au sein d'une gamme de résistivité, la gamme de résistivité comprenant au moins la résistivité du substrat échantillon, dans lequel la vitesse de recombinaison est caractérisée en fonction de la résistivité des échantillons témoins et dans lequel la vitesse de recombinaison considérée à l'étape de détermination est la vitesse de recombinaison associée à une résistivité sensiblement égale à la résistivité du substrat échantillon ;

- la mesure de la durée de vie effective des porteurs de charges du substrat échantillon est effectuée à un premier niveau d'injection, et dans lequel la caractérisation de la vitesse de recombinaison est effectuée à un deuxième niveau d'injection, et dans lequel les premier et deuxième niveaux d'injection sont sensiblement égaux ;

- les premier et deuxième niveaux d'injection sont inférieurs à $10^{16}$ cm$^{-3}$ et de préférence inférieurs ou égaux à $5 \cdot 10^{15}$ ;

- la durée de vie volumique des porteurs de charge du substrat témoin est connue pour un troisième niveau d'injection et dans lequel les premier, deuxième et troisième niveaux d'injections sont sensiblement identiques ;

- la sous-étape de fourniture comprend une sous-étape de mesure de la durée de vie volumique des porteurs de charge du substrat témoin, la sous-étape de mesure comprenant :

  - la passivation du substrat témoin au moyen de structures de passivation présentant une vitesse de recombinaison associées inférieure à 1 cm/s ;

  - la détermination de la durée de vie volumique des porteurs de charge du substrat témoin à partir de la mesure de la durée de vie effective du substrat témoin passivé.

Par "sensiblement égal" on entend égal à plus ou moins 10% près.

L'invention concerne également un système de détermination de la durée de vie volumique des porteurs de charge d'un substrat échantillon, le système de détermination comprenant un dispositif de mesure et des moyens configurés pour mettre en oeuvre les étapes d'un procédé de détermination selon l'invention.

L'invention concerne aussi un produit programme d'ordinateur comprenant des instructions qui conduisent le système de détermination selon l'invention à mettre en oeuvre les étapes du procédé de détermination selon l'invention.

L'invention concerne également un support lisible par ordinateur, sur lequel est enregistré le programme d'ordinateur précité.

L'invention concerne aussi un procédé de tri d'une pluralité de substrats échantillons comprenant les étapes suivantes :

- pour chaque substrat échantillon :

  - déterminer la durée de vie volumique des porteurs de charge du substrat échantillon au moyen d'un procédé de détermination selon l'invention ;

  - écarter le substrat échantillon lorsque la durée de vie volumique des porteurs de charge du substrat échantillon est inférieure à une durée de vie volumique seuil ou lorsque le rapport de la durée de vie volumique des porteurs de charge du substrat échantillon par la résistivité du substrat échantillon est inférieur à un rapport seuil.

Le rapport seuil peut être le rapport de la durée de vie volumique seuil par une résistivité seuil.

L'invention concerne également un système de tri d'une pluralité de substrats échantillons comprenant :

**EP 4 016 596 A1**

- un système de détermination configuré pour déterminer la durée de vie volumique des porteurs de charge de chaque substrat échantillon au moyen d'un procédé de détermination selon l'invention ; et

- un dispositif de routage configuré pour écarter le substrat échantillon lorsque la durée de vie volumique des porteurs de charge du substrat échantillon est inférieure à une durée de vie volumique seuil ou lorsque le rapport de la durée de vie volumique des porteurs de charge du substrat échantillon par la résistivité du substrat échantillon est inférieur à un rapport seuil.

L'invention concerne aussi un produit programme d'ordinateur comprenant des instructions qui conduisent le système de tri selon l'invention à mettre en oeuvre les étapes du procédé de tri selon l'invention.

Support lisible par ordinateur, sur lequel est enregistré le programme d'ordinateur précité.

L'invention et ses différentes applications seront mieux comprises à la lecture de la description qui suit et à l'examen des figures qui l'accompagnent.

## BRÈVE DESCRIPTION DES FIGURES

Les figures sont présentées à titre indicatif et nullement limitatif de l'invention.

[Fig. 1] représente schématiquement un premier mode de mise en oeuvre d'un procédé de détermination selon l'invention.

[Fig. 2] représente schématiquement un deuxième mode de mise en oeuvre du procédé de détermination selon l'invention.

[Fig. 3] montre des résultats expérimentaux de résistivités obtenus sur une pluralité de substrats.

[Fig. 4] montre des résultats expérimentaux de vitesses de recombinaison en fonction des résistivités de substrats témoins.

[Fig. 5] représente schématiquement un troisième mode de mise en oeuvre du procédé de détermination selon l'invention.

[Fig. 6] représente schématiquement un quatrième mode de mise en oeuvre du procédé de détermination selon l'invention.

[Fig. 7] représente schématiquement un premier exemple d'empilement.

[Fig. 8] représente schématiquement un deuxième exemple d'empilement.

[Fig. 9] représente schématiquement une extraction d'une durée de vie effective des porteurs de charge obtenue selon un mode de mesure de durée de vie effective des porteurs de charges.

[Fig. 10] représente schématiquement un cinquième mode de mise en oeuvre du procédé de détermination selon l'invention.

[Fig. 11] montre des résultats expérimentaux de mesure de durées de vie volumique des porteurs de charge et de résistivités sur une pluralité de substrats.

[Fig. 12] représente schématiquement un mode de réalisation d'un système de détermination.

[Fig. 13] représente schématiquement un mode de mise en oeuvre d'un procédé de tri de substrats.

[Fig. 14] représente schématiquement un mode de réalisation d'un système de tri.

Sauf précision contraire, un même élément apparaissant sur des figures différentes présente une référence unique.

Les figures sont présentées à titre indicatif et nullement limitatif de l'invention.

**DESCRIPTION DÉTAILLÉE**

Dans la suite de la description, il sera indifféremment fait mention de :

- des porteurs de charges pour désigner les porteurs de charges minoritaires ;

- la durée de vie effective pour désigner la durée de vie effective des porteurs de charge ;

- la durée de vie volumique pour désigner la durée de vie volumique des porteurs de charge ;

- la vitesse de recombinaison pour désigner la vitesse effective de recombinaison des porteurs de charge minoritaires.

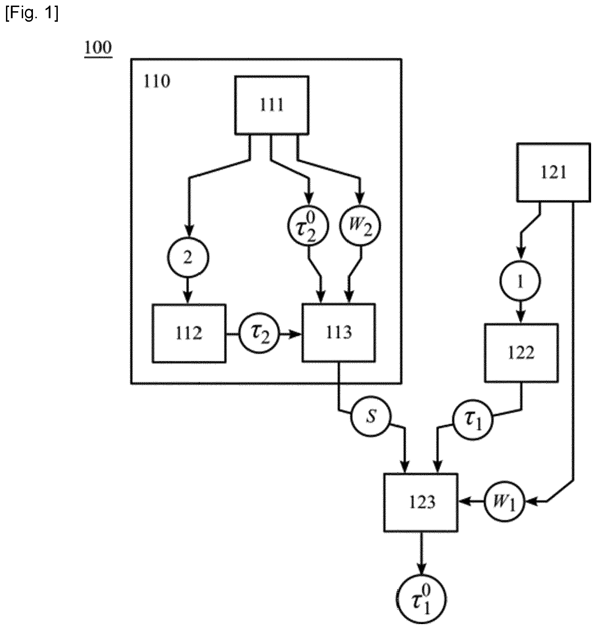

La figure 1 représente schématiquement un premier mode de mise en oeuvre d'un procédé de détermination 100 de la durée de vie volumique $\tau_1^0$ d'un substrat échantillon 1. Le substrat 1 peut être un précurseur de cellule photovoltaïque à hétérojonction, c'est-à-dire un produit intermédiaire obtenu au cours de la fabrication d'une cellule photovoltaïque à hétérojonction.

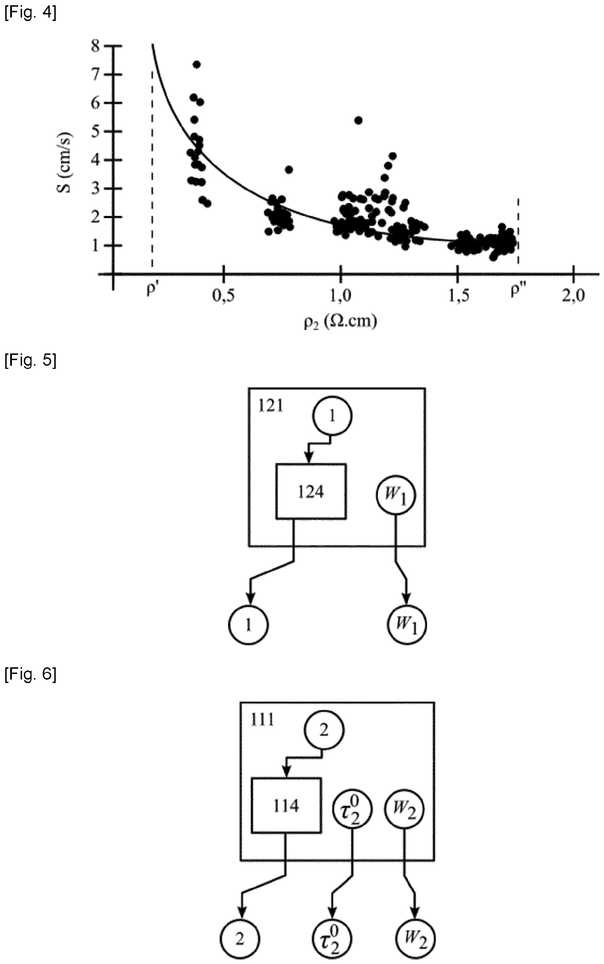

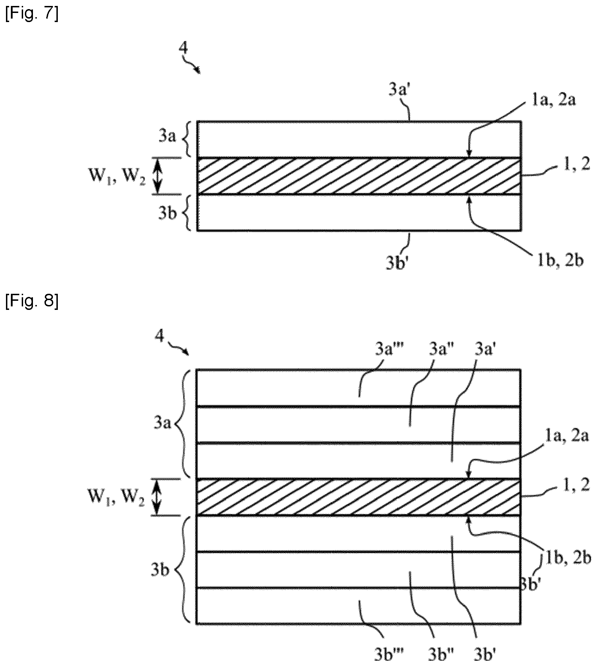

Le procédé de détermination 100 comprend une étape de fourniture 121 du substrat échantillon 1. Le substrat échantillon 1 présente une première face et une deuxième face, opposée à la première face. Les première et deuxième faces sont espacées d'une première épaisseur $W_1$. Les première et deuxième faces du substrat échantillon 1 sont passivés respectivement au moyen d'une première et d'une deuxième structures de passivation. La première structure de passivation est disposée sur la première face du substrat échantillon 1. La deuxième structure de passivation est disposée sur la deuxième face du substrat échantillon 1. L'étape de fourniture 121 est décrite plus en détail par la figure 5. Le substrat échantillon 1 et les structures de passivations sont présentés plus en détails par les figures 7 et 8.

La passivation par dépôt de structures de passivation offre une stabilité électronique au substrat échantillon 1, réduisant par exemple l'interaction des surfaces avec l'air ambiant.

Le procédé de détermination 100 comprend également une étape de caractérisation 110 permettant d'obtenir une vitesse de recombinaison $S$ associée aux première et deuxième structures de passivation.

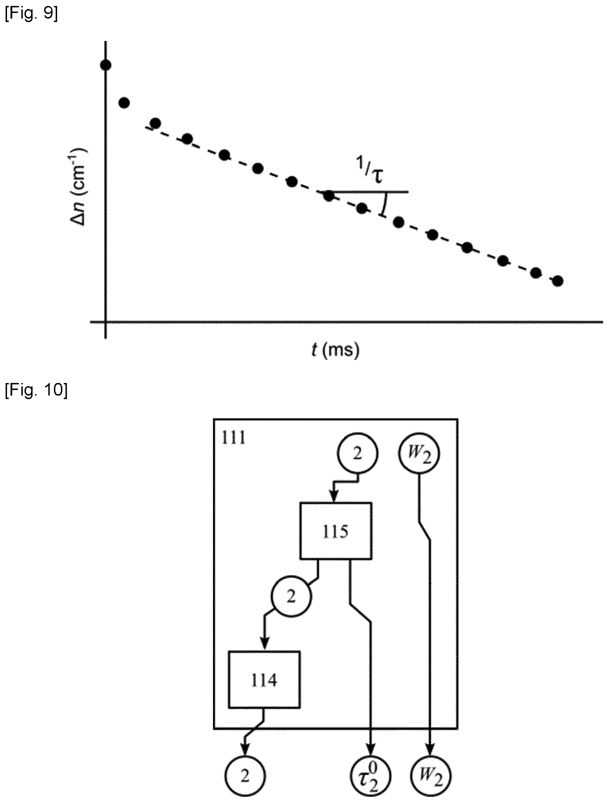

Le procédé de détermination 100 comprend en outre une étape de mesure 122 de la durée de vie effective $\tau_1$ du substrat échantillon 1. Un mode de mise en oeuvre de l'étape de mesure 122 appliqué au substrat échantillon 1 est décrit par la figure 9.

Enfin, le procédé de détermination 100 comprend une étape de détermination 123 permettant d'obtenir la durée de vie volumique $\tau_1^0$ du substrat échantillon 1. Ladite durée de vie volumique $\tau_1^0$ est obtenue à partir de :

- la vitesse de recombinaison S associée aux première et deuxième structures de passivation, obtenue à l'issue de l'étape de caractérisation 110 ; et

- la durée de vie effective $\tau_1$ du substrat échantillon 1, obtenue à l'issue de l'étape de mesure 122 sur le substrat échantillon 1.

La durée de vie volumique $\tau_1^0$ est, par exemple, obtenue grâce à la relation :

$$[Math. 3] \qquad \frac{1}{\tau_1} = \frac{1}{\tau_1^0} + \frac{2\,S}{W_1}$$

où $W_1$ est la première épaisseur du substrat échantillon 1.

Ainsi, grâce au procédé de détermination 100, on obtient la durée de vie volumique $\tau_1^0$ du substrat échantillon 1. La connaissance de la vitesse de recombinaison $S$ associée aux première et deuxième structures de passivation permet d'estimer la durée de vie volumique $\tau_1^0$ d'un substrat, quel que soit le substrat considéré tant qu'il comprend les première et deuxième structures de passivation, disposées respectivement sur ses première et deuxième faces.

Afin d'améliorer la précision de détermination de la durée de vie volumique $\tau_1^0$, on réalisera préférentiellement l'étape de mesure 122 sur une pluralité de substrats échantillons 1. La pluralité de substrats échantillons 1 comprend préférentiellement des substrats issus d'un même lingot semiconducteur et encore préférentiellement dans une même portion. De cette façon les propriétés électroniques telles que la résistivité et la durée de vie volumique varient peu voire sont identiques. Ces substrats 1 peuvent être appelés "substrats jumeaux" car ils présentent des propriétés proches voire identiques.Avantageusement, l'étape de mesure 122 est réalisée sur au moins cinq substrats jumeaux. La durée de vie effective $\tau_1$ considérée à l'issue des étapes de mesure 122 sera la moyenne des valeurs individuelles de chaque substrat jumeaux. Si la distribution de valeurs individuelles présente une forme fortement asymétrique, la médiane sera préférablement considérée.

L'étape de caractérisation 110 met en oeuvre un substrat témoin 2. Le substrat témoin 2 présente une première face et une deuxième face, opposée à la première face. Les première et deuxième faces du substrat témoin 2 sont espacées d'une deuxième épaisseur $W_2$. De la même manière que le substrat échantillon 1, le substrat témoin 2 est passivé sur chacune de ses faces au moyen de la première et de la deuxième structure de passivation. La première structure de passivation est disposée sur la première face du substrat témoin 2 et la deuxième structure de passivation est disposée sur la deuxième face du substrat témoin 2.

Les substrats échantillon et témoin 1, 2 et les structures de passivations sont présentés plus en détails en référence aux figures 7 et 8.

La vitesse de recombinaison d'un semiconducteur est liée à la densité de défauts présents aux surfaces dudit semiconducteur. La densité de défauts dépend fortement du type et de la qualité de la passivation qui est réalisée aux surfaces dudit semiconducteur. Ainsi, réaliser une passivation identique sur deux substrats différents permet d'obtenir des vitesses de recombinaison proches, sinon identiques, sur chacun des substrats. Selon le procédé de détermination 100, les faces des substrats échantillon et témoin 1, 2 présentent les mêmes structures de passivation et donc des vitesses de recombinaison comparables.

La mise en oeuvre du substrat témoin 2 pour déterminer la vitesse de recombinaison $S$ permet de conserver l'intégrité du substrat échantillon 1 tout en obtenant la même valeur. De plus, l'obtention de la durée de vie volumique $\tau_1^0$ du substrat échantillon 1 n'est pas soumise à la mise en oeuvre de couches passivations de très haute qualité, telle que l'immersion dans une solution passivante telle qu'un acide, incompatible avec l'industrie photovoltaïque. Au contraire, le procédé de détermination 100 permet de déterminer la durée de vie volumique $\tau_1^0$ du substrat échantillon 1 en utilisant les procédés de passivation de l'industrie photovoltaïque.

Afin de déterminer la vitesse de recombinaison, la connaissance de la durée de vie volumique $\tau_2^0$ du substrat témoin 2 est nécessaire. L'étape de caractérisation 110 comprend une sous-étape de fourniture 111 d'un substrat témoin 2 passivé au moyen des première et deuxième structures de passivation et dont la durée de vie volumique $\tau_2^0$ est connue. Une méthode d'obtention de la durée de vie volumique $\tau_2^0$ du substrat témoin 2 est présentée à la figure 6.

L'étape de caractérisation 110 comprend également une sous-étape de mesure 112 de la durée de vie effective $\tau_2$ du substrat témoin 2. Elle est préférentiellement réalisée de la même façon que l'étape de mesure 122 permettant d'obtenir la durée de vie effective $\tau_1$ du substrat échantillon 1.

L'étape de caractérisation 110 comprend également une sous-étape de détermination 113 de la vitesse de recombinaison $S$ associée aux première et deuxième structures de passivation. La vitesse de recombinaison $S$ est obtenue à partir :

- de la durée de vie effective du substrat témoins 2, obtenue à l'issue de la sous-étape de mesure 112 ; et

- de la durée de vie volumique $\tau_2^0$ du substrat témoin 2, connue.

La vitesse de recombinaison S peut être obtenue grâce à la relation :

[Math. 4]

$$\frac{1}{\tau_2} = \frac{1}{\tau_2^0} + \frac{2\,S}{W_2}$$

où $W_2$ est l'épaisseur du substrat témoin 2.

La caractérisation de la vitesse de recombinaison $S$ et la détermination de la durée de vie volumique $\tau_1^0$ doivent être réalisées sur des substrats comprenant les même première et deuxième structures de passivation.

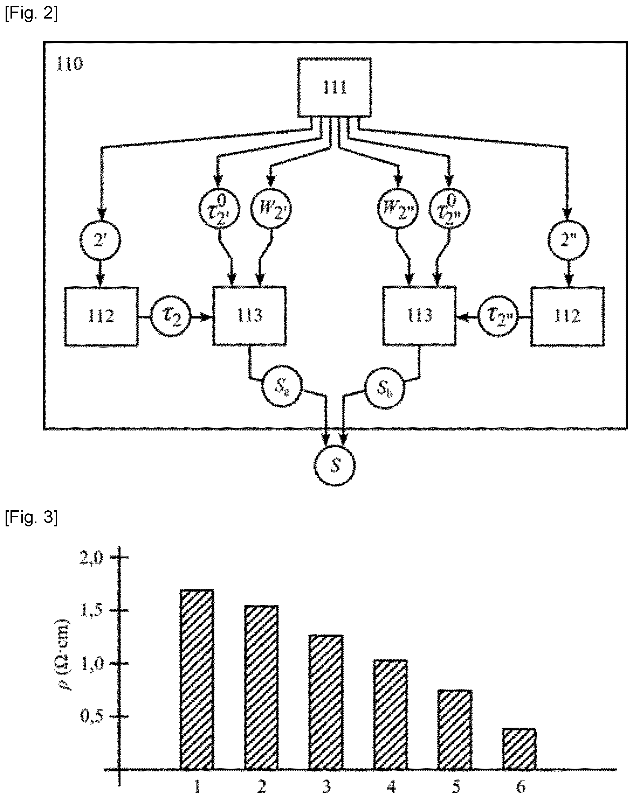

La figure 2 représente un mode de mise en oeuvre de l'étape de caractérisation 110 dans lequel une première et une deuxième vitesses de recombinaison $S_a$, $S_b$ sont déterminées. La première vitesse de recombinaison $S_a$ correspond à la vitesse de recombinaison associée à la première structure de passivation. La deuxième vitesse de recombinaison $S_b$ correspond à la vitesse de recombinaison associée à la deuxième structure de passivation. La moyenne des première et une deuxième vitesses de recombinaison $S_a$, $S_b$ correspond à la vitesse de recombinaison effective $S$ (utilisée entre autres dans l'étape de détermination 123) :

[Math. 5]

$$\frac{S_a + S_b}{2} = S$$

Dissocier les vitesses de recombinaison par structure de passivation permet de constituer une base de données de vitesses de recombinaison associée à une pluralité de structures de passivation. Ainsi, pour obtenir une vitesse de recombinaison à partir d'une configuration de structures de passivation, il suffit de calculer la vitesse de recombinaison moyenne à partir des vitesses de recombinaison associées à ladite configuration. Considérons, par exemple, un substrat échantillon pouvant être passivé par des structures de passivation de type A ou B. Connaissant les vitesses de recombinaison associée à chaque type de structure, il est aisé de calculer la vitesse de recombinaison moyenne d'un substrat passivé selon l'une des combinaisons A/A, A/B ou B/B.

Selon cette mise en oeuvre de l'étape de caractérisation 110, il est fourni à l'étape 111 un premier et un deuxième substrat témoin 2', 2" dont les durées de vie volumiques $\tau_{2'}^0$, $\tau_{2''}^0$, et les épaisseurs $W_{2'}$, $W_{2''}$, sont connues. Le premier substrat témoin 2' est passivé au moyen de la première structure de passivation 3a sur chacune de ses première et deuxième faces. Le deuxième substrat témoin 2" est passivé au moyen de la deuxième structure de passivation 3b sur chacune de ses première et deuxième faces. La réalisation des sous-étapes de mesure 112 et de détermination 113 sur chacun des premier et deuxième substrats témoins 2', 2" permet d'obtenir les première et une deuxième vitesses de recombinaison $S_a$, $S_b$.

Selon une variante, le même substrat témoin 2 est mis en oeuvre, passivé selon l'une puis l'autre des configurations précitées.

La vitesse de recombinaison $S$ est fonction de la résistivité $\rho$ des substrats 1, 2. L'omission de cette dépendance peut induire des erreurs sur la détermination 123 de la durée de vie volumique $\tau_2^0$ des substrats échantillon 1.

Il est par conséquent préférable de caractériser 110 la vitesse de recombinaison S(ρ) pour une valeur de résistivité $\rho$ sensiblement égale à la résistivité $\rho_1$ du substrat échantillon 1. Pour cela, le choix du substrat témoin 2 peut être réalisé de telle manière que sa résistivité $\rho_2$ soit sensiblement égale à la résistivité $\rho_1$ du substrat échantillon 1. Par sensiblement égale, on entend égal à 10% près.

La figure 3 représente des valeurs de résistivité $\rho$ mesurées sur six substrats découpés dans un même lingot semiconducteur. Le premier substrat est découpé à proximité de la tête du lingot semiconducteur et le sixième substrat est découpé à proximité du pied du lingot semiconducteur. Dans cet exemple les substrats sont équidistants entre eux. La résistivité $\rho$ des substrats utilisés pour la fabrication des cellules photovoltaïques peut varier de manière significative. Par exemple, la migration de phosphore lors de la croissance du lingot implique une variation de la résistivité le long du lingot. Les fabricants de substrats proposent d'ailleurs des gammes de résistivité pouvant s'étendre de 1 $\Omega \cdot$ cm à 5 $\Omega \cdot$ cm, ou encore de 0,3 $\Omega \cdot$ cm à 2,1$\Omega \cdot$ cm. La résistivité d'un substrat peut être mesurée par contact, au moyen d'un dispositif de mesure quatre pointes, ou sans contact, au moyen d'un dispositif de mesure par inductif.

Afin d'améliorer encore la précision de détermination de la durée de vie volumique $\tau_1^0$ du substrat échantillon 1, l'étape de caractérisation 110 prend avantageusement en compte la dépendance de la vitesse de recombinaison S(p) en fonction de la résistivité $\rho$.

La figure 4 représente un exemple de vitesse de recombinaison $S$ issue de l'étape de caractérisation 110 lorsque cette dernière prend en compte la dépendance de la vitesse de recombinaison S(p) en fonction de la résistivité $\rho$. Dans cet exemple, il est fourni une pluralité de substrats témoins 2 passivés au moyen des mêmes première et deuxième structures de passivation 3a, 3b. Les substrats témoins 2 présentent des résistivités $\rho_2$ différentes, définissant une gamme de résistivité s'étendant entre une valeur minimale $\rho'$ et une valeur maximale $\rho''$. Dans la figure 4, la gamme de résistivité s'étend de $\rho'$ = 0.34 $\Omega \cdot$ cm à $\rho''$ = 1.7 $\Omega \cdot$ cm. Chaque vitesse de recombinaison $S(\rho_2)$ est obtenue par la réalisation de la sous-étape de mesure 112 et de détermination 113 pour chaque substrat témoin 2. Les vitesses de recombinaison $S(\rho_2)$ sont représentées par des points dans la figure 4. Un ajustement (en trait plein) des valeurs expérimentales $S(\rho_2)$ permet d'obtenir une loi reliant la vitesse de recombinaison $S$ en fonction de la résistivité $\rho_2$. La figure 4 montre par exemple une loi de puissance S(p) = 1,75 $\rho^{0,9}$ cm/s. Dans cet exemple, le niveau de confiance dans les données expérimentales et l'ajustement permet d'ailleurs d'élargir la gamme de résistivité à considérer, s'étendant ainsi de $\rho'$ = 0.2 $\Omega \cdot$ cm à $\rho''$ = 1.7 $\Omega \cdot$ cm.

La figure 4 montre la forte dépendance entre la vitesse de recombinaison $S$ et la résistivité $\rho$. On tirera donc un avantage à déterminer un ajustement de la vitesse de recombinaison $S$ sur une gamme de résistivité $\rho'$, $\rho''$ comprenant des bornes de résistivités utilisées, notamment la résistivité $\rho_1$ du substrat échantillon 1. L'étape de détermination 123 de la durée de vie volumique $\tau_1^0$ du substrat échantillon 1 considère préférentiellement la vitesse de recombinaison $S$ associée à la résistivité du substrat échantillon $S(\rho_1)$.

Le recours à une pluralité d'échantillons témoins 2 permet d'améliorer la précision de détermination de la vitesse de recombinaison S(p).

La vitesse de recombinaison S(p) doit être recaractérisée à chaque modification des procédés ou des équipements permettant la réalisation des structures de passivation. Il s'agit par exemple d'un changement dans une étape de texturation, gravure ou nettoyage, ou d'un changement de réglage ou de cibles lors de la PVD (par exemple pour le dépôt des couches amorphe).

Toutefois, le fait de recaractériser la vitesse de recombinaison $S$, même sans changement notable des procédés ou des équipements, est un excellent moyen de déterminer la stabilité desdits procédés et équipements, notamment lorsqu'ils font partie d'une ligne de fabrication de cellules photovoltaïques. Il se peut que le vieillissement des équipements de passivation ou des réactifs (cibles, gaz, chimie, etc.) entraîne une variation de qualité des structures de passivation. Réaliser l'étape de caractérisation 110 à des instants différents permet de déterminer et comparer les vitesses de recombinaison $S$ et donc l'évolution de la qualité des structures de passivation. Il est d'ailleurs recommandé d'établir la vitesse de recombinaison S(p) sur une plage de résistivité $\rho'$, $\rho''$ couvrant les résistivités des substrats échantillons 1 mis en oeuvre par lesdits procédés et équipements.

Afin de simplifier et accélérer la mise à jour régulière de la loi S(p), l'étape de caractérisation 110 pourra avantageusement être réalisée à l'aide du même substrat témoin 2 subissant les étapes de passivation. Le dépôt de structures de passivation est préférentiellement réalisé après décapage et nettoyage poussé des surfaces du substrat témoin 2.

La figure 5 représente schématique un mode de mise en oeuvre de l'étape de fourniture 121, comprenant une étape de passivation 124 du substrat échantillon 1. L'étape de passivation 124 permet de former les première et deuxième structures de passivation disposées sur, respectivement, les première et deuxième faces du substrat échantillon 1. Cette étape est nécessaire lorsque le substrat échantillon 1 est fourni nu (c'est à dire sans structure de passivation) ou avec des structures de passivation temporaires, ne correspondant pas aux structures destinées à être mise en oeuvre par la suite. Ainsi, grâce à l'étape de passivation 124, on obtient un substrat échantillon 1 passivé, pouvant servir de précurseur à la fabrication d'une cellule photovoltaïque.

Dans le mode de mise en oeuvre de la figure 6, la sous-étape de fourniture 111 comprend également une sous-étape de passivation 114 du substrat témoin 2. Cette sous-étape de passivation 114 permet de former les première et deuxième structures de passivation disposées sur, respectivement, les première et deuxième faces du substrat témoin 2. De la même manière que l'étape de passivation 124 précitée, le substrat témoin 2 peut être fourni sans structure de passivation ou avec des structures de passivation temporaires, ne correspondant pas aux structures de passivation du substrat échantillon 1.

Afin d'assurer une bonne estimation de la vitesse de recombinaison $S$ du substrat échantillon 1 passivé, il est préférable d'inclure l'étape et la sous-étape de passivation 124, 114 au procédé de détermination 100. Il peut d'ailleurs être recommandé de réaliser les structures de passivations des substrats 1, 2 au moyen du même équipement. De cette manière, on garantit une bonne fidélité entre la vitesse de recombinaison $S$ du substrat échantillon 1 passivé et la vitesse de recombinaison $S$ du substrat témoin 2 passivé.

Les structures de passivation peuvent être formées par dépôt chimique en phase vapeur assisté par plasma (ou PECVD, pour *"Plasma-Enhanced Chemical Vapor Deposition"* en anglais) consécutif à une étape de gravure et un nettoyage poussé des faces 1a, 1b, 2a, 2b des substrats 1, 2.

La figure 7 et la figure 8 représentent schématiquement deux exemples d'un substrat 1, 2 passivé au moyen des première et deuxième structures de passivation 3a, 3b. Ces exemples sont applicables tant au substrat échantillon 1 qu'au substrat témoin 2, tous deux étant simplement désignés par le terme "substrat". Dans ces exemples, le substrat passivé est un empilement comprenant le substrat, nu, et une ou plusieurs couches de passivation déposée sur chacune des faces du substrat. L'empilement peut former un précurseur de cellule photovoltaïque. Le substrat 1, 2 est par exemple en silicium cristallin, dopé de type n ou p.

Dans l'exemple de la figure 7, chaque structure de passivation 3a, 3b comprend une couche de passivation 3a', 3b' en silicium amorphe hydrogéné intrinsèque, disposée sur chacune des première et deuxième faces 1a, 2a, 1b, 2b du substrat 1, 2. Il s'agit de l'empilement 4 le plus simple, ne comportant qu'une couche de passivation par face.

L'empilement peut également comprendre une jonction p-n formée, par exemple, par la superposition de deux matériaux semi-conducteurs ayant des conductivités opposées, tels que le silicium cristallin dopé de type n et le silicium amorphe dopé de type p (il s'agit alors d'un précurseur de cellule photovoltaïque à hétérojonction de silicium).

Ainsi, dans l'exemple de la figure 8, chaque structure de passivation 3a, 3b comprend, en plus des couches de passivation 3a', 3b', une couche de silicium amorphe dopé 3a", 3b", disposée sur chaque couche de passivation 3a', 3b'. Les couches de silicium amorphe dopé 3a", 3b" sont dopées selon un type de conductivité opposé. La couche de silicium amorphe dopé 3a" de la première structure de passivation est dopée du même type de conductivité que le substrat 1, 2. La couche de silicium amorphe dopé 3b" de la deuxième structure de passivation est dopée du type de conductivité opposé. L'hétérojonction est formée par le substrat 1, 2 en silicium cristallin dopé et la couche de silicium amorphe dopée 3b" de la deuxième structure de passivation 3b, cette dernière couche 3b" formant l'émetteur de l'empilement 4.

Le dopage des couches de silicium amorphe dopé 3a", 3b" peut être réalisé par ajout de phosphore (pour un dopage de type n) ou par ajout de bore (pour un dopage de type p).

Chaque structure de passivation 3a, 3b peut comprendre également une couche d'oxyde transparent conducteur 3a''', 3b''' (ou TCO, pour « Transparent Conductive Oxide » en anglais) disposée sur la couche de silicium amorphe dopé 3a", 3b".

L'épaisseur $W_1$, $W_2$ du substrat 1, 2 est mesurée entre la première face 1a, 2a et la deuxième face 1b, 2b. Elle peut être déterminée sans contact, au moyen d'une mesure capacitive, par une mesure physique directe, au moyen d'un pied à coulisse micrométrique ou encore par une mesure de la masse du substrat 1, 2, connaissant la densité massique du silicium et la géométrie du substrat 1, 2.

La qualité de la passivation des substrats 1, 2 influence directement la vitesse de recombinaison $S$. Toutefois, une vitesse de recombinaison élevée, typiquement $S > 100$ cm/s peut nuire à la précision de détermination des durées de vie volumique $\tau_1^0$, $\tau_2^0$ des substrats échantillon et témoin 1, 2. Il est donc préférable que les structures de passivation 3a, 3b soient configurées pour offrir une vitesse de recombinaison $S < 100$ cm/s. Plus basse est la vitesse de recombinaison et meilleure est la précision de détermination des durées de vie volumiques $\tau_1^0$, $\tau_2^0$. Pour cette raison on préférera mettre en oeuvre des structures de passivation 3a, 3b offrant une vitesse de recombinaison $S < 10$ cm/s ou encore inférieure.

Les procédés de fabrication de cellules photovoltaïques, tels que la passivation ou la réticulation des résines d'interconnexion, mettent en oeuvre des températures élevées, par exemple supérieure à 200 °C, pouvant avoir un effet sur la durée de vie volumique des substrats. Par exemple, une température dépassant 300 °C provoque une augmentation de la densité de centres de recombinaison en volume et, de fait, une réduction de la durée de vie volumique. La qualité cristalline des substrats peut d'ailleurs également être altérée, mais dans une moindre mesure, pour des températures inférieures à 300 °C. L'accumulation d'altérations occasionnées par un historique de températures défini alors un budget thermique.

Il est souhaitable que le budget thermique du procédé de détermination 100 soit comparable au budget thermique de la fabrication de cellules photovoltaïques. Les étapes contribuant au budget thermique du procédé de détermination 100 sont les étape et sous-étape de passivation 121, 111. Il est préférable que ces étape et sous-étape 121, 111 soient réalisées de manière à garantir une température du substrat 1, 2 inférieure à 300 °C et de manière préférée inférieure à 250 °C.

Les couches de silicium amorphe 3a', 3a", 3b', 3b" sont également sensibles à la température. Après plusieurs secondes passées au-delà de 250 °C, le silicium amorphe se dégrade de façon irrémédiable, entraînant une augmentation de la vitesse de recombinaison et également un réduction des performances de la cellule photovoltaïque formée à partir du substrat échantillon 1. Il est donc préférable que les étape et sous-étape de passivation 121, 111 soient réalisées de manière à garantir une température des structures de passivation 3a, 3b inférieure à 250 °C.

La figure 9 représente un mode de mesure de la durée de vie effective $\tau$ d'un substrat. Ce mode de mesure est par exemple mis en oeuvre au sein de l'étape de mesure 122 de la durée de vie effective $\tau_1$ du substrat échantillon 1 et/ou lors de la sous-étape de mesure 112 de la durée de vie effective $\tau_2$ du substrat témoin 2.

La durée de vie effective $\tau$ d'un substrat peut-être déterminée par une mesure de la décroissance de la conductivité $\sigma$ du substrat. En effet, la conductivité $\sigma(\Delta n)$ du substrat est proportionnelle à la densité de porteurs de charge minoritaire $\Delta n$ dans le substrat, aussi appelé niveau d'injection. Aussi, la densité de porteurs de charge $\Delta n$ décroît du fait des recombinaisons qui ont lieu dans le volume et aux surfaces du substrat. La conductivité décroit proportionnellement à :

[Math. 6]

$$\frac{\mathrm{d}\big(\sigma(\Delta n)\big)}{\mathrm{d}t} \propto -1/\tau$$

Ainsi, une mesure de la décroissance de la conductivité $\sigma(\Delta n)$ du substrat permet de déterminer directement la durée de vie effective des porteurs de charge $\tau$ au sein du substrat. La figure 9 représente schématiquement un exemple de décroissance de la conductivité des porteurs de charge au sein d'un substrat brièvement illuminé.

Pour de forts niveaux d'injection $\Delta n > 10^{16}$ cm$^{-3}$, les mécanismes volumique de recombinaisons ne dépendent que peu de la densité de centres de recombinaison au sein du substrat mais principalement des recombinaisons intrinsèques telles que les recombinaisons Auger et les recombinaisons radiatives. Une mesure de décroissance de la conductivité à fort niveau d'injection ne permet donc pas de déterminer précisément la durée de vie volumique lié à la densité de centres de recombinaison au sein du substrat. Elle ne présente donc pas d'intérêt pour évaluer la qualité de substrats.

En revanche, pour de faibles niveaux d'injection $\Delta n < 10^{16}$ cm$^{-3}$, les mécanismes volumiques de recombinaisons sont principalement gouvernés par la densité des centres de recombinaison au sein du substrat. Ainsi, une mesure de décroissance de la conductivité à faible niveau d'injection présente un intérêt pour l'évaluation de la qualité des substrats, notamment ceux destinés au domaine photovoltaïque.

La mesure de durée de vie effective des substrats échantillon et témoins est préférentiellement réalisée à faible niveau d'injection $\Delta n < 10^{16}$ cm$^{-3}$, notamment lorsqu'elle met en oeuvre la décroissance de photoconductivité. Lorsque le niveau d'injection initial $\Delta n$ dépasse $10^{16}$ cm$^{-3}$ alors l'ajustement de la décroissance de conductivité d$(\sigma(\Delta n))$/d$t$ est préférentiellement réalisée sur une partie de la courbe pour laquelle la densité de porteurs de charge $\Delta n$ est plus faible ($\Delta n < 10^{16}$ cm$^{-3}$).

La mesure de durée de vie effective $\tau_1(\Delta n)$, $\tau_2(\Delta n)$ dépend du niveau d'injection $\Delta n$. Les durées de vie volumique $\tau_1^0$, $\tau_2^0$ dépendent donc indirectement du niveau d'injection. Afin que ces grandeurs puissent être calculées correctement, on veillera à réaliser les mesures des durées de vie effective $\tau_1$, $\tau_2$ à des niveaux d'injection sensiblement égaux. Par sensiblement égal, on entend égal à 10 % près. De préférence, les niveaux d'injection sont inférieurs ou égaux à $\Delta n = 5 \cdot 10^{14}$ cm$^{-3}$.

Un dispositif de mesure configuré pour mettre en oeuvre une mesure de décroissance de la conductivité d'un substrat comprend préférentiellement une source de rayonnement configurée pour illuminer brièvement le substrat de sorte que des porteurs de charges minoritaires soient photogénérés. Le dispositif de mesure est préférentiellement configuré pour photogénérer une densité de porteurs de charge suffisante pour réaliser la mesure tout en restant inférieure ou égale à $\Delta n = 5 \cdot 10^{14}$ cm$^{-3}$. Le dispositif de mesure peut également comprendre un moyen de mesure de la conductivité du substrat, par exemple par couplage inductif. Le dispositif de mesure est par exemple un dispositif de mesure commercialisé par la société Sinton Instruments™ sous la marque Sinton™.

La présence de métallisations sur les structures de passivation peut nuire à la mesure de durée de vie effective basée sur le principe de mesure de la décroissance de la conductivité. Toutefois, la présence de métallisations permet de déterminer une caractéristique I(V) du substrat passivé en fonction de l'illumination (technique dite "Suns-Voc" en anglais) permettant également d'estimer la durée de vie effective du substrat.

La vitesse de recombinaison $S(\Delta n)$, comme les durées de vie effectives $\tau_1(\Delta n)$, $\tau_2(\Delta n)$, dépend du niveau d'injection $\Delta n$. Il est donc préférable de déterminer la vitesse de recombinaison $S(\Delta n)$ pour un même niveau d'injection $\Delta n$ déterminé, notamment lorsque les variations en fonction du niveau d'injection sont fortes. Le niveau d'injection $\Delta n$ est préférentiellement choisi inférieur à $10^{15}$ cm$^{-3}$ ou inférieur ou égal à $5 \cdot 10^{14}$ cm$^{-3}$. Cette gamme est représentative du niveau d'injection d'une cellule photovoltaïque en fonctionnement. De manière préférée, les niveaux d'injection permettant de mesurer les durées de vie effectives $\tau_1(\Delta n)$, $\tau_2(\Delta n)$ et la vitesse de recombinaison $S(\Delta n)$ sont sensiblement égaux.

Lorsque la durée de vie volumique $\tau_2^0$ du substrat témoin 2 est fournie par le fabricant de lingot semiconducteur, le niveau d'injection $\Delta n$ considéré pour les mesures est préférentiellement substantiellement égale au niveau d'injection utilisé par le fabricant de lingot. Cette valeur est par exemple $\Delta n \approx 5 \cdot 10^{14}$ cm$^{-3}$.

Le substrat témoin 2 peut être fourni par un fabricant de substrats. Avant de réaliser la découpe des substrats, le fabricant de substrats peut déduire la durée de vie volumique $\tau_2^0$ du substrat témoin 2 à partir d'une mesure de la durée de vie effective $\tau$ réalisée en plusieurs positions du lingot semiconducteur au sein duquel sera découpé le substrat témoin 2. L'épaisseur W d'un lingot étant grande W >> 1, elle permet de s'affranchir de la contribution de la vitesse de recombinaison $S$ sur la durée de vie effective $\tau$. Ainsi la mesure de la durée de vie effective $\tau$ sur le lingot donne une estimation fiable et directe de la durée de vie volumique $\tau_2^0$ du substrat témoin 2. La mesure de la durée de vie effective $\tau$ du lingot peut être réalisée par mesure de la décroissance de conductivité. Cette technique est fiable dans la mesure où l'utilisation d'un éclairage à grande longueur d'onde (par exemple dans le proche infrarouge) permet de s'affranchir de la contribution des surfaces.

Lorsque le fabricant de substrats ne fournit pas de valeur de durée de vie volumique $\tau_2^0$ ou alors une valeur à laquelle il est difficile de se fier (par exemple : précision insuffisante ou doutes sur le mode opératoire), alors, la sous-étape de fourniture 111 comprend avantageusement une sous-étape de mesure 115 de la durée de vie volumique $\tau_2^0$ du substrat témoin 2. Au sein de cette sous-étape de mesure 115, la mise en oeuvre d'un procédé de détermination de la durée de vie volumique connu de l'art antérieur est envisageable. En effet, l'estimation de la durée de vie volumique du substrat témoin 2 n'est pas soumise aux mêmes exigences que la détermination 100 de la durée de vie volumique du substrat échantillon 1. Un procédé de détermination de la durée de vie volumique du substrat témoin 2 par amincissement partiel du substrat témoin 2 est donc envisageable. L'amincissement doit toutefois rester partiel car le substrat témoin 2 doit pouvoir être utilisé lors de l'étape de caractérisation 110. Un procédé de détermination de la durée de vie volumique du substrat témoin 2 comprenant la passivation des surfaces du substrat témoin 2 par immersion dans une solution passivante et leur illumination est également envisageable.

Afin de compenser l'amincissement du substrat témoin 2 lors de la sous-étape de mesure 115, le substrat témoin 2 présente préférentiellement une épaisseur initiale supérieure à l'épaisseur $W_1$ du substrat échantillon 1. De cette manière, l'amincissement du substrat témoin 2 peut être prononcé, offrant une bonne précision de mesure de la durée de vie volumique, tout en permettant d'obtenir un substrat témoin 2 présentant une épaisseur finale comparable aux épaisseurs standards dans le domaine de la fabrication de cellules photovoltaïques. Par exemple, l'épaisseur initiale du substrat témoin 2 peut être de l'ordre de 160 $\mu$m. Lors de la sous-étape de mesure 115, le substrat témoin peut être aminci jusqu'à 140 $\mu$m, qui correspond à une épaisseur standard de l'industrie.

Un mode de mise en oeuvre préférentiel de l'étape de mesure 115 comprend : la passivation du substrat témoin 2 et la détermination de la durée de vie volumique des porteurs de charge $\tau_2^0$ du substrat témoin 2 à partir de la mesure de la durée de vie effective du substrat témoin 2 passivé.

La passivation peut être réalisée au moyen de structures de passivation présentant une vitesse de recombinaison aux surfaces très basse, par exemple $S < 1$ cm/s. Il s'agit par exemple du dépôt de structures de passivation de type bicouches après un nettoyage poussé des surfaces. Les structures de passivation bicouches comprennent par exemple une couche de silicium amorphe intrinsèque et une couche de silicium amorphe dopé (pouvant être de type n si le substrat est dopé de type n). Si les structures de passivation sont suffisamment épaisses, par exemple d'une épaisseur supérieure à 20 nm, la vitesse de recombinaison résiduelle aux surfaces est d'environ 1 cm/s et peut être négligée dans le bilan global de durée de vie effective. Des structures de passivation encore plus performantes peuvent être envisagées. Le document [Bonilla & al., Phys. Status Solidi Rapid Res. Lett., 1-5 (2016)] divulgue un procédé permettant d'atteindre une vitesse de recombinaison $S < 0,1$ cm/s. Les structures de passivation sont de type tri-couche. Les structures de passivation sont déposées à basse température, inférieure à 250°C et comprennent une couche de silicium amorphe, une couche d'oxyde de silicium et une couche de nitrure de silicium. La durée de vie effective du substrat témoin 2 passivé peut être obtenue par une mesure de la décroissance de conductivité du substrat témoin 2 selon le mode de mesure décrit précédemment.

Tout autre procédé connu de l'art antérieur permettant d'estimer la durée de vie volumique du substrat témoin 2 est bien entendu envisageable dès lors qu'il permet une utilisation ultérieure du substrat témoin 2 (notamment lors de l'étape de caractérisation 110).

Une alternative peut également prévoir la mise en oeuvre d'une sous-étape de mesure 115 connue de l'art antérieur mais ne permettant plus l'utilisation ultérieure du substrat. Afin de conserver un substrat témoin 2 utilisable lors de l'étape de caractérisation 110, on réalisera alors la sous-étape de mesure 115 sur un substrat jumeau du substrat témoin 2. Par exemple, un substrat prélevé dans le même lingot semiconducteur et montrant des propriétés électriques comparables, voire identiques.

La sous-étape d'estimation 115 intervient préférentiellement avant la sous-étape de passivation 114 de sorte que le substrat échantillon 2 issue de la sous-étape de fourniture 111 puisse être mis en oeuvre au sein de l'étape de caractérisation 110.

Afin de simplifier la mise en oeuvre de la sous-étape de fourniture 111, la durée de vie volumique $\tau_2^0$ peut être définie arbitrairement. La durée de vie volumique peut par exemple être définie comme $\tau_2^0 \rightarrow \infty$. Dans ce cas il s'agit d'une hypothèse très forte. Toutefois elle peut s'avérer suffisante pour des substrats témoins 2 ayant des durées de vie volumiques $\tau_2^0$ élevées. Elle permet également de simplifier la sous-étape de fourniture 111 lorsque la mise en oeuvre d'équipements de caractérisation n'est pas possible. Une limite haute de la durée de vie volumique $\tau_2^0$ peut également être déterminée à partir de connaissances générales sur le type de matériau utilisé, les processus mis en oeuvre ou le niveau d'injection considéré. Par exemple, pour de forts niveaux d'injection $\Delta n > 5.10^{15} \text{cm}^{-3}$, la durée de vie volumique est limitée par les recombinaisons Auger ou radiatives.

L'étape de fourniture 111 peut prévoir la formation d'une collection de *i* substrats témoins 2 de différentes résistivités pouvant être utilisés pour déterminer une vitesse de recombinaison moyenne. Ainsi, la précision de caractérisation de la vitesse de recombinaison *S* s'en trouve améliorée. Pour cela, les durées de vie volumique $\tau_{2i}^0$ et les épaisseurs $W_{2i}$ associées au i^ème substrat de la collection de substrats témoins 2 sont également fournis 111 avec la collection de i substrats témoins 2.

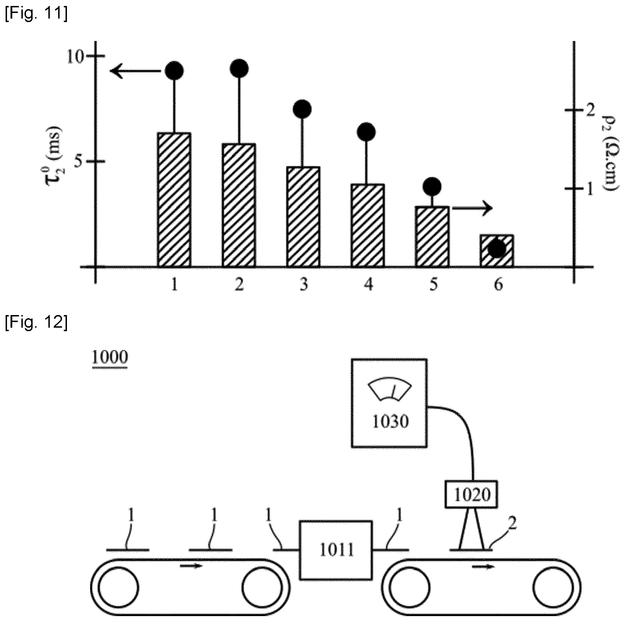

La collection de substrats témoins 2 peut également être utilisée pour caractériser la vitesse de recombinaison S(p) sur une large gamme de résistivités. La figure 11 montre un exemple de mesures de durée de vie volumique réalisées sur une collection de substrats témoins issus d'un même lingot semiconducteur mais découpés à différentes positions. Il s'agit de la collection de substrats témoins dont les résultats de résistivité sont présentés dans la figure 3. Les substrats témoins sont dopés de type n et ont été passivés de manière symétrique, les structures de passivation comprenant chacune une couche de silicium amorphe intrinsèque et une couche de silicium amorphe dopée de type n. La caractérisation 110 de la vitesse de recombinaison a été réalisée par une mesure de la décroissance de la conductivité à un niveau d'injection égale à $\Delta n = 5 \cdot 10^{14} \text{ cm}^{-3}$. La gamme de résistivité, matérialisée par deux barres hachurées (ordonnée à droite), s'étend de 0,3 $\Omega \cdot$ cm à 1,7 $\Omega \cdot$ cm. Les cercles pleins (ordonnée à gauche) correspondent aux vitesses de recombinaison associées à chaque substrat témoin. Un ajustement (non montré) des mesures de vitesses de recombinaison S(p) en fonction des mesures de résistivités est égale à :

[Math. 7]

$$S(\rho) = -0,2\,\rho + 0,45 \text{ cm/s}$$

La figure 12 représente une mode de réalisation d'un système de détermination 1000 configuré pour réaliser le procédé de détermination 100 de la durée de vie volumique $\tau_1^0$ d'un substrat échantillon 1 à partir d'un substrat témoin 2 présentant une durée de vie volumique $\tau_2^0$ connue. Le système 1000 comprend un dispositif de mesure 1020 et des moyens, tels qu'un calculateur 1030, configurés pour mettre en oeuvre le procédé de détermination 100.

Le dispositif de mesure 1020 peut par exemple comprendre un équipement de mesure de décroissance de la conductivité tel que décrit précédemment. Le dispositif est, par exemple, configuré pour réaliser l'étape de mesure 122 de la durée de vie effective $\tau_1$ du substrat échantillon 1 et/ou la sous-étape de mesure 112 de la durée de vie effective $\tau_2$ du substrat témoin 2.

Le calculateur 1030 est par exemple un microprocesseur d'ordinateur. Il est configuré pour réaliser au moins l'étape de détermination 123 de la durée de vie volumique $\tau_1^0$ du substrat échantillon 1 et/ou la sous-étape de détermination 113 de la vitesse de recombinaison *S* associée aux première et deuxième structures de passivation.

Dans le mode de réalisation de la figure 12, le système de détermination 1000 comprend également un premier banc de passivation 1011. Le premier banc de passivation 1011 est par exemple configuré pour réaliser la sous-étape de fourniture 111 et/ou l'étape de fourniture 124 consistant à fournir les substrats échantillons et témoins 1, 2 passivés au moyen des première et deuxième structures de passivation.

Le substrat échantillon 1 et le substrat témoin 2 suivent avantageusement la même ligne de production. De cette manière ils sont passivés et caractérisés avec les mêmes équipements, permettant d'améliorer la précision de mesure de la durée de vie volumique du substrat échantillon 1. Le substrat témoin 2 peut-être introduit en premier dans le système de détermination 1000 afin de permettre la caractérisation de la vitesse de recombinaison des structures de passivation.

Le système de détermination 1000 peut être intégré à une ligne de fabrication, permettant notamment de déterminer la durée de vie volumique d'une pluralité de substrats échantillons, passant les uns après les autres dans le système de détermination 1000.

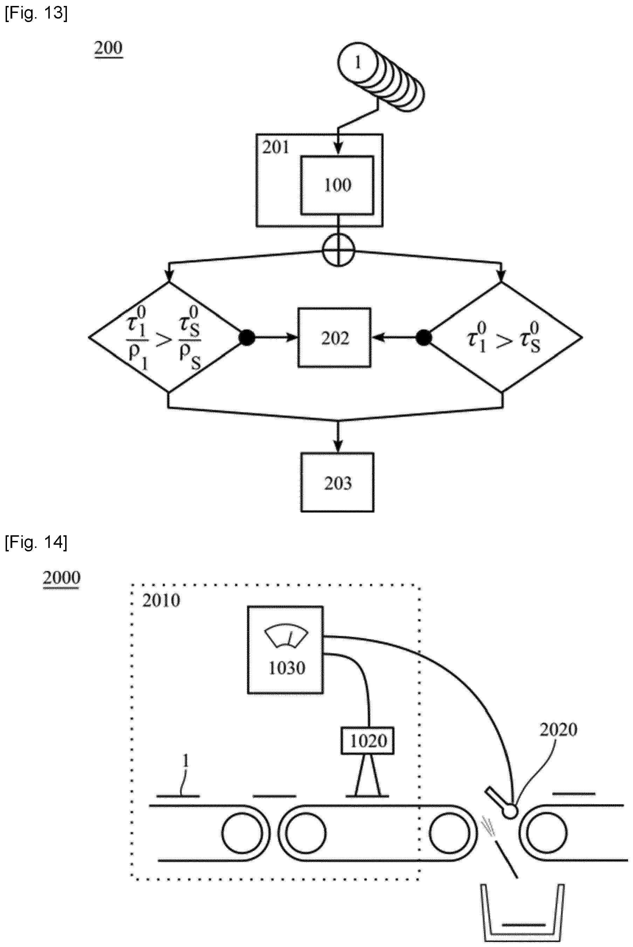

La figure 13 représente schématiquement un procédé de tri 200 d'une pluralité de substrats échantillons 1. Le procédé de tri 200 comprend, pour chaque substrat échantillon 1, une étape de détermination 201 de la durée de vie volumique des porteurs de charge $\tau_1^0$ du substrat échantillon 1. L'étape de détermination 201 met avantageusement en oeuvre le procédé de détermination 100 décrit précédemment. Le procédé de tri 200 comprend également, pour chaque substrat échantillon 1, une comparaison du résultat obtenu lors de l'étape de détermination 201 avec un critère de qualité. Lorsqu'un substrat échantillon 1 ne satisfait pas au critère de qualité, il est écarté 202 du lot.

Le critère de qualité est défini par une durée de vie volumique seuil $\tau_S^0$ ou par un rapport seuil. Dans le premier cas, le substrat échantillon 1 est écarté 202 lorsque la durée de vie volumique $\tau_1^0$ du substrat échantillon 1 est inférieure à la durée de vie volumique seuil $\tau_S^0$. Dans le deuxième cas, le substrat échantillon 1 est écarté 202 lorsque le rapport de la durée de vie volumique par la résistivité $\tau_1^0 / \rho_1$ du substrat échantillon 1 est inférieur au rapport seuil. Le rapport peut être défini comme étant le rapport de la durée de vie volumique seuil par une résistivité seuil $\tau_S^0 / \rho_S$. En d'autres mots, dans le deuxième cas, le substrat échantillon 1 est écarté lorsque :

[Math. 8]

$$\frac{\tau_1^0}{\rho_1} < \frac{\tau_S^0}{\rho_S}$$

Le procédé de tri 200 peut par exemple être intégré à une ligne de fabrication de cellule photovoltaïque. Il permet notamment d'écarter 202 les substrats échantillons 1 n'atteignant pas les exigences minimales de l'industrie photovoltaïque, telle qu'une durée de vie volumique seuil et/ou une résistivité seuil. Les substrats écartés peuvent être mis au rebut, redirigés vers un procédé de fabrication alternatif ou alors contrôlé par le fabricant de substrat afin de déterminer une raison de la variation des propriétés des substrats.

Les substrats échantillons dépassant la durée de vie volumique seuil $\tau_S^0$ sont par exemple orientés vers un autre procédé 203 tel qu'un procédé de fabrication de cellules photovoltaïques.

La figure 14 représente schématiquement un système de tri 2000 d'une pluralité de substrats échantillons 1. Le système de tri 2000 comprend :

- un système de détermination 2010 configuré pour déterminer 201 la durée de vie volumique des porteurs de charge $\tau_1^0$ de chaque substrat échantillon 1 par la mise en oeuvre du procédé de détermination 100 ; et

- un dispositif de routage 2020 configuré pour écarter 202 le substrat échantillon 1 selon l'une des conditions décrites par la figure 13.

**Revendications**

1. Procédé de détermination (100) de la durée de vie volumique des porteurs de charge $\left(\tau_1^0\right)$ d'un substrat échantillon (1), le procédé comprenant :

   - une étape de fourniture (121) du substrat échantillon (1), passivé au moyen d'une première structure de passivation (3a) disposée sur une première face (1a) du substrat échantillon (1) et d'une deuxième structure de passivation (3b) disposée sur une deuxième face (1b) du substrat échantillon (1), la deuxième face (1b) du substrat échantillon (1) étant opposée à la première face (1a) du substrat échantillon (1), la première structure de passivation (3a) et la deuxième structure de passivation (3b) comprenant chacune une couche de passivation (3a', 3b') en silicium amorphe hydrogéné intrinsèque, la première structure de passivation (3a) comprenant en outre une couche de silicium amorphe (3a") dopée selon un premier type de conductivité, disposée sur la couche de passivation (3a') en silicium amorphe hydrogéné intrinsèque, la deuxième structure de passivation (3b) comprenant en outre une couche de silicium amorphe (3b") dopée selon un deuxième type de conductivité, disposée sur la couche de passivation (3b') en silicium amorphe hydrogéné intrinsèque, le deuxième type de conductivité étant opposé au premier type de conductivité, le substrat échantillon (1) présentant une première épaisseur ($W_1$);
   - une étape de caractérisation (110) d'une vitesse de recombinaison ($S$) associée à la première structure de passivation et à la deuxième structure de passivation, ladite étape (110) comprenant :

      - une sous-étape de fourniture (111) d'un substrat témoin (2) passivé au moyen de la première structure de passivation (3a) disposée sur une première face (2a) du substrat témoin (2) et de la deuxième structure de passivation (3b) disposée sur une deuxième face (2b) du substrat témoin (2), la deuxième face (2b) du substrat témoin (2) étant opposée à la première face (2a) du substrat témoin (2), le substrat témoin (2) présentant une deuxième épaisseur ($W_2$) et une durée de vie volumique des porteurs de charge $\left(\tau_2^0\right)$ connue ;
      - une sous-étape de mesure (112) de la durée de vie effective des porteurs de charge $\left(\tau_2\right)$ du substrat témoin (2) ;
      - une sous-étape de détermination (113) de la vitesse de recombinaison ($S$) associée aux première et deuxième structures de passivation (3a, 3b) à partir des durées de vie effective et volumique des porteurs de charge $\left(\tau_2,\ \tau_2^0\right)$ du substrat témoin (2), et de la deuxième épaisseur ($W_2$) du substrat témoin (2) ;

   - une étape de mesure (122) de la durée de vie effective des porteurs de charges ($\tau_1$) du substrat échantillon (1) ;
   - une étape de détermination (123) de la durée de vie volumique des porteurs de charges $\left(\tau_1^0\right)$ du substrat échantillon (1) à partir de la durée de vie effective des porteurs de charge ($\tau_1$) du substrat échantillon (1), de la première épaisseur ($W_1$) du substrat échantillon (1) et de la vitesse de recombinaison ($S$) associée aux première et deuxième structures de passivation (3a, 3b).

2. Procédé de détermination (100) selon la revendication précédente, dans lequel la sous-étape de fourniture (111) comprend la passivation du substrat témoin (2) de manière à déposer la première structure de passivation (3a) sur la première face (2a) du substrat témoin (2) et la deuxième structure de passivation (3b) sur la deuxième face (2b) du substrat témoin (2).

3. Procédé de détermination (100) selon l'une des revendications précédentes, dans lequel l'étape de fourniture (121) comprend la passivation du substrat échantillon (1) de manière à déposer la première structure de passivation (3a) sur la première face (1a) du substrat échantillon (1) et la deuxième structure de passivation (3b) sur la deuxième face (1b) du substrat échantillon (1).

4. Procédé de détermination (100) selon l'une des revendications 2 ou 3, dans lequel le dépôt des première et deuxième structures de passivation (3a, 3b) est effectué sous une température inférieure à 250 °C.

5. Procédé de détermination (100) selon l'une des revendications précédentes, dans lequel la première structure de passivation (3a) et la deuxième structure de passivation (3b) comprennent chacune une couche d'oxyde transparent conducteur (3a''', 3b''') disposée sur la couche de silicium amorphe dopée.

6. Procédé de détermination (100) selon l'une des revendications précédentes, dans lequel les première et deuxième structures de passivation (3a, 3b) sont telles que la vitesse de recombinaison (S) associée aux première et deuxième structures de passivation (3a, 3b) est inférieure à 100 cm/s.

7. Procédé de détermination (100) selon l'une des revendications précédentes, dans lequel la résistivité ($\rho_2$) du substrat témoin (2) est sensiblement égale à la résistivité du substrat échantillon (1).

8. Procédé de détermination (100) selon l'une des revendications 1 à 6, dans lequel la sous-étape de fourniture (111) consiste à fournir une pluralité d'échantillons témoins (2) présentant des résistivités ($\rho_2$) différentes au sein d'une gamme de résistivité ($\rho'$, $\rho''$), la gamme de résistivité ($\rho'$, $\rho''$) comprenant au moins la résistivité du substrat échantillon (1), dans lequel la vitesse de recombinaison (S) est **caractérisée** (110) en fonction de la résistivité ($\rho_2$) des échantillons témoins (2) et dans lequel la vitesse de recombinaison (S) considérée à l'étape de détermination (132) est la vitesse de recombinaison (S) associée à une résistivité sensiblement égale à la résistivité du substrat échantillon (1).

9. Procédé de détermination (100) selon l'une des revendications précédentes, dans lequel la mesure (122) de la durée de vie effective des porteurs de charges ($\tau_1$) du substrat échantillon (1) est effectuée à un premier niveau d'injection, et dans lequel la caractérisation (110) de la vitesse de recombinaison (S) est effectuée à un deuxième niveau d'injection, et dans lequel les premier et deuxième niveaux d'injection sont sensiblement égaux.

10. Procédé de détermination (100) selon la revendication précédente, dans lequel les premier et deuxième niveaux d'injection sont inférieurs à $10^{16}$ cm$^{-3}$.

11. Procédé de détermination (100) selon l'une des deux revendications précédentes, dans lequel la durée de vie volumique des porteurs de charge $\left(\tau_2^0\right)$ du substrat témoin (2) est connue pour un troisième niveau d'injection et dans lequel les premier, deuxième et troisième niveaux d'injections sont sensiblement identiques.

12. Procédé de détermination (100) selon l'une des revendications précédentes, dans lequel la sous-étape de fourniture (111) comprend une sous-étape de mesure (115) de la durée de vie volumique des porteurs de charge $\left(\tau_2^0\right)$ du substrat témoin (2), la sous-étape de mesure (115) comprenant :

   - la passivation du substrat témoin (2) au moyen de structures de passivation présentant une vitesse de recombinaison associées inférieure à 1 cm/s ;

   - la détermination de la durée de vie volumique des porteurs de charge $\left(\tau_2^0\right)$ du substrat témoin (2) à partir de la mesure de la durée de vie effective du substrat témoin (2) passivé.

13. Système de détermination (1000) de la durée de vie volumique des porteurs de charge $\left(\tau_1^0\right)$ d'un substrat échantillon (1), le système de détermination (1000) comprenant un dispositif de mesure (1020) et des moyens configurés pour mettre en oeuvre les étapes d'un procédé de détermination (100) selon l'une quelconque des revendications 1 à 12.

14. Produit programme d'ordinateur comprenant des instructions qui conduisent le système de détermination (1000) selon la revendication 13 à mettre en oeuvre les étapes du procédé de détermination (100) selon l'une des revendications 1 à 12.

15. Support lisible par ordinateur, sur lequel est enregistré le programme d'ordinateur selon la revendication 14.

16. Procédé de tri (200) d'une pluralité de substrats échantillons (1) comprenant les étapes suivantes :

- pour chaque substrat échantillon (1) :

- déterminer (201) la durée de vie volumique des porteurs de charge $(\tau_1^0)$ du substrat échantillon (1) au moyen d'un procédé de détermination (100) selon l'une des revendications 1 à 12 ;

- écarter (202) le substrat échantillon (1) lorsque la durée de vie volumique des porteurs de charge $(\tau_1^0)$ du substrat échantillon (1) est inférieure à une durée de vie volumique seuil $(\tau_S^0)$ ou lorsque le rapport de la durée de vie volumique des porteurs de charge du substrat échantillon (1) par la résistivité du substrat échantillon (1) est inférieur à un rapport seuil.

17. Système de tri (2000) d'une pluralité de substrats échantillons (1) comprenant :

- un système de détermination (2010) configuré pour déterminer (201) la durée de vie volumique des porteurs de charge $(\tau_1^0)$ de chaque substrat échantillon (1) au moyen d'un procédé de détermination (100) selon l'une des revendications 1 à 12 ; et
- un dispositif de routage (2010) configuré pour écarter (202) le substrat échantillon (1) lorsque la durée de vie volumique des porteurs de charge $(\tau_1^0)$ du substrat échantillon (1) est inférieure à une durée de vie volumique seuil $(\tau_S^0)$ ou lorsque le rapport de la durée de vie volumique des porteurs de charge du substrat échantillon (1) par la résistivité du substrat échantillon (1) est inférieur à un rapport seuil.

18. Produit programme d'ordinateur comprenant des instructions qui conduisent le système de tri (2000) selon la revendication 17 à mettre en oeuvre les étapes du procédé de tri (200) selon la revendication 16.

19. Support lisible par ordinateur, sur lequel est enregistré le programme d'ordinateur selon la revendication 18.

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

[Fig. 12]

[Fig. 13]

200

[Fig. 14]

2000

Europäisches Patentamt
European Patent Office
Office européen des brevets

# RAPPORT DE RECHERCHE EUROPEENNE

Numéro de la demande

EP 21 21 4476

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2014/303919 A1 (SAMESHIMA TOSHIYUKI [JP]) 9 octobre 2014 (2014-10-09) * tableaux 1 et 2; alinéas [0002], [0042], [0068] - [0074]; figures 1, 3 * | 1-19 | INV. H01L21/66 H01L31/0747 H02S50/10 |
| Y | JAY FRÉDÉRIC ET AL: "Exclusively Thermal Donor-doped Cz Wafers for Silicon Heterojunction Solar Cell Technology", ENERGY PROCEDIA , vol. 55 19 septembre 2014 (2014-09-19), pages 533-538, XP055833049, NL ISSN: 1876-6102, DOI: 10.1016/j.egypro.2014.08.020 Extrait de l'Internet: URL:http://dx.doi.org/10.1016/j.egypro.2014.08.020 [extrait le 2021-08-18] * introduction; figure 1 * | 1-19 | |
| Y | SCHMIDT JAN ET AL: "Accurate method for the determination of bulk minority-carrier lifetimes of mono- and multicrystalline silicon wafers", JOURNAL OF APPLIED PHYSICS, AMERICAN INSTITUTE OF PHYSICS, US, vol. 81, no. 9, 1 mai 1997 (1997-05-01), page 6186, XP012042661, ISSN: 0021-8979, DOI: 10.1063/1.364403 | 8,12 | |
| A | * équation 3, tableau 1; figures 1, 7 * | 1,9-11 | |

DOMAINES TECHNIQUES RECHERCHES (IPC)

H01L

-/--

Le présent rapport a été établi pour toutes les revendications

| Lieu de la recherche | Date d'achèvement de la recherche | Examinateur |
|---|---|---|
| Munich | 29 avril 2022 | Ronnås, Katharina |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 1 de 2

Europäisches
Patentamt

European
Patent Office

Office européen
des brevets

# RAPPORT DE RECHERCHE EUROPEENNE

Numéro de la demande

EP 21 21 4476

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | YABLONOVITCH E ET AL: "UNUSUALLY LOW SURFACE-RECOMBINATION VELOCITY ON SILLICON AND GERMANIUM SURFACES", PHYSICAL REVIEW LETTERS, AMERICAN PHYSICAL SOCIETY, US, vol. 57, no. 2, 14 juillet 1986 (1986-07-14), pages 249-252, XP000612996, ISSN: 0031-9007, DOI: 10.1103/PHYSREVLETT.57.249 * équation 1; figures 2, 3 * ----- | 1,9-11 | |
| Y | US 2019/247889 A1 (LETTY ELÉNORE [FR] ET AL) 15 août 2019 (2019-08-15) * alinéas [0012], [0064]; figure 1 * ----- | 16-19 | |
| | | | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 29 avril 2022 | Ronnås, Katharina |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................
& : membre de la même famille, document correspondant

EPO FORM 1503 03.82 (P04C02)

page 2 de 2

## EP 4 016 596 A1

ANNEXE AU RAPPORT DE RECHERCHE EUROPEENNE
RELATIF A LA DEMANDE DE BREVET EUROPEEN NO.

EP 21 21 4476

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-04-2022

| Document brevet cité au rapport de recherche | Date de publication | Membre(s) de la famille de brevet(s) | Date de publication |
|---|---|---|---|
| US 2014303919 A1 | 09-10-2014 | CN 104094389 A | 08-10-2014 |
| | | JP 6052536 B2 | 27-12-2016 |
| | | JP 2013145868 A | 25-07-2013 |
| | | US 2014303919 A1 | 09-10-2014 |
| | | WO 2013089088 A1 | 20-06-2013 |
| US 2019247889 A1 | 15-08-2019 | CA 3036402 A1 | 15-03-2018 |
| | | CN 109844966 A | 04-06-2019 |
| | | EP 3510640 A1 | 17-07-2019 |
| | | FR 3055563 A1 | 09-03-2018 |
| | | HU E051167 T2 | 01-03-2021 |
| | | KR 20190046958 A | 07-05-2019 |
| | | US 2019247889 A1 | 15-08-2019 |
| | | WO 2018046855 A1 | 15-03-2018 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **YABLONOVITCH.** Unusually Low Surface-Recombination Velocity on Silicon and Germanium Surfaces. PRL, Juillet 1986, vol. 57

- **GRANT.** Evaluation of the Bulk Lifetime of Silicon Wafers by Immersion in Hydrofluoric Acid and Illumination. *ECS J. Solid State Sci. Technol.,* Juillet 2012, vol. 1, 55
- **BONILLA.** *Phys. Status Solidi Rapid Res. Lett.,* 2016, vol. 1-5